Europäisches Patentamt

European Patent Office

Office européen des brevets

(11) Publication number: **0 337 395**
**A2**

# (12) EUROPEAN PATENT APPLICATION

(21) Application number: **89106417.2**

(22) Date of filing: **11.04.89**

(51) Int. Cl.⁴: **H01L 29/54 , H01L 29/62**

(30) Priority: **12.04.88 JP 89505/88**

(43) Date of publication of application:
**18.10.89 Bulletin 89/42**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Fujioka, Hiroshi c/o FUJITSU**
**LIMITED**
**Patent Department 1015 Kamikodanaka**
**Nakahara-ku Kawasaki-shi Kanagawa 211(JP)**

(74) Representative: **Sunderland, James Harry et al**
**HASELTINE LAKE & CO Hazlitt House 28**
**Southampton Buildings Chancery Lane**
**London WC2A 1AT(GB)**

(54) A semiconductor device suitable for cryogenic operations.

(57) A semiconductor device for operation under cryogenic conditions has a structure similar to that of conventional bipolar transistors, but a different impurity doping profile. The impurity concentration for a "base" layer (14) of the device is controlled to be larger than $5 \times 10^{18}$ cm$^{-3}$, preferably $1 \times 10^{19}$ cm$^{-3}$ or more, and the impurity concentration for an "emitter" layer (15) is controlled to be in a limited range less than the above value, but greater than $1 \times 10^{17}$ cm$^{-3}$. The above doping profile enables the device to operate satisfactorily at temperatures below about minus 100 decrees centigrade, down to liquid nitrogen temperatures, and further makes it suitable for a high-speed operation.

EP 0 337 395 A2

## A semi conductor device suitable for cryogenic operations.

Bipolar transistors used in a high-speed computer system are required to be suitable for high-speed operations, and therefore it is desired that parameters such as a base resistance, emitter resistance, collector capacitance and emitter capacitance be as small as possible. Moreover, it is desirable that associated wirings on a circuit board have low resistance and small stray capacitance. It is known that cooling a key portion of such a system is an effective way of removing heat generated therein, offering the possibility of achieving a compact size, with short wirings, and of improving operational delay times. On the other hand, conventional bipolar transistors have current amplification factors $h_{FE}$ which decrease with decrease in the operating temperature of the bipolar transistors.

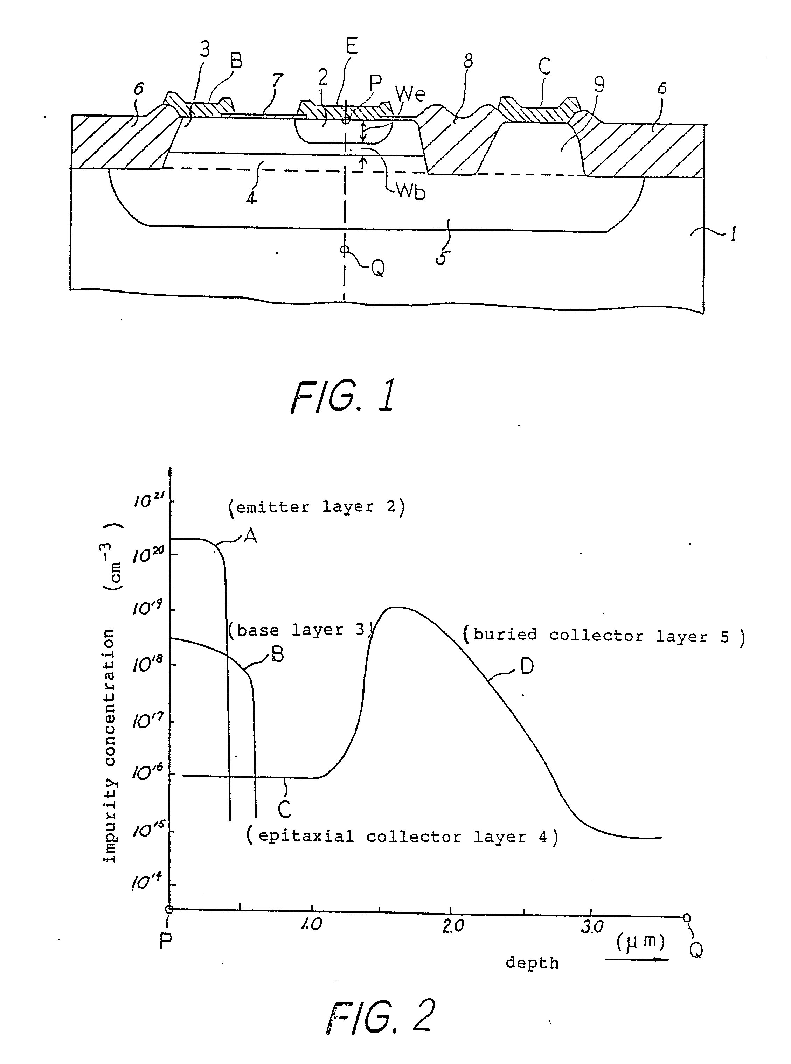

Fig. 1 is a schematic cross-section of a known transistor. A p-type silicon substrate 1 is used. In the substrate 1, an $n^+$-type buried collector layer 5 is formed by impurity diffusion. An $n^-$-type layer is grown thereon and thick silicon dioxide ($SiO_2$) layers 6 and 8 are formed in the epitaxial layer to isolate each active element from neighbouring elements and from a collector lead-out layer 9 for the active element. Thereafter, boron ions are implanted selectively, which results in the formation of an epitaxial collector layer 4 and a p-type base layer 3 formed thereon. An $n^+$-emitter layer 2 is formed in the base layer 3 by an arsenic ion implantation. A thin oxide layer 7 is also formed, to isolate a base electrode B from an emitter electrode E. C is a collector electrode. The above-described method of forming the transistor is an example, and many other methods may be applicable.

Fig. 2 is a graph which shows impurity concentration curves of the n-p-n transistor of Fig. 1, and in which the abscissa indicates depth from the surface (vertical distance from point P in Fig. 1) of the active element. Curve A shows impurity concentration data for the emitter layer 2; curve B shows impurity concentration data for the base layer 3; and curves C and D show impurity concentration data for the epitaxial collector layer 4 and buried collector layer 5 respectively.

As seen from Fig. 2, the impurity concentration $N_e$ (curve A) of the emitter layer 2 is much higher than the impurity concentration $N_b$ of the base layer 3. This is because the current amplification factor $h_{FE}$ (also called a common-emitter current gain) of the above bipolar transistor obeys the following proportionality equation.

$$h_{FE} \propto \frac{W_e \times N_e}{W_b \times W_b} \exp\left(\frac{\Delta E_{gb} - \Delta E_{ge}}{kT}\right) \qquad (1)$$

where $W_e$ and $W_b$ denote an emitter width and base width respectively as shown in Fig. 1, and $\Delta E_{gb}$ denotes a bandgap narrowing effect in the base layer 3, and $\Delta E_{ge}$ denotes a bandgap narrowing effect in the emitter layer 2. k is the Boltzmann's constant, and T is an operating temperature in degrees Kelvin.

A bandgap narrowing effect $\Delta E_g$ is expressed in meV (milli-electron-volts) and represents an amount of a bandgap shrinkage (change in value), measured experimentally, when impurities are introduced into silicon. The value of the exponential term $\exp(\Delta E_{gb} - \Delta E_{ge})$ in equation (1) for conventional transistors operating at room temperatures is comparatively small. In order to obtain a desirably high $h_{FE}$ value such as 100, it is desirable that $N_e \gg N_b$. However, it is very difficult to obtain $N_e$ greater than $1 \times 10^{21}$ cm$^{-3}$ because of saturation in impurity doping. A sufficiently high $h_{FE}$ value, therefore, can be obtained by decreasing the impurity concentration $N_b$ of the base layer 3 to a lower amount, as compared with $N_e$ of the emitter layer 2, for example to an amount such as less than $5 \times 10^{18}$ cm$^{-3}$.

On the other hand, decreasing the impurity concentration $N_b$ results in a decrease of a base resistance $R_b$, which results in deterioration in relation to high-speed operation of the transistor. As a compromise, $N_b$ values ranging from $1 \times 10^{17}$ cm$^{-3}$ to $5 \times 10^{18}$ cm$^{-3}$ are generally used for conventional bipolar transistors.

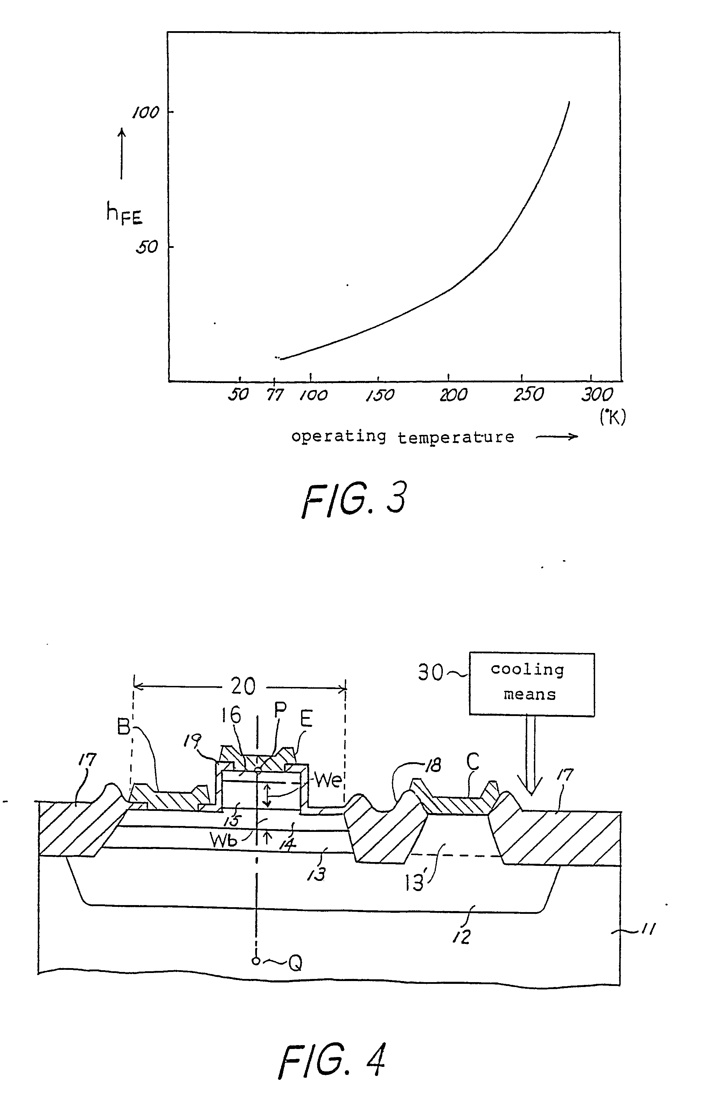

When a bipolar transistor of the above kind is installed in a system and cooled, with the object of achieving high-speed operation, and when the operating temperature thereof is maintained at an extreme low temperature such as 77°K (liquid nitrogen), the exponential term in equation (1) decreases rapidly, taking a value of the order of $10^{-4}$ to $10^{-6}$. Therefore it is impossible to obtain a sufficiently high current amplification factor $h_{FE}$ in a low temperature range. A typical characteristic curve of $h_{FE}$ versus operating temperature for a prior bipolar transistor is shown in the graph of Fig. 3.

According to the present invention there is provided a semiconductor device for operation at temperatures below about minus 100 degrees centigrade, said semiconductor device comprising:-

2

a semiconductor substrate,

a first semiconductor active region, of a first conductivity type, formed on the substrate,

a second semiconductor active region, of a second conductivity type, opposite to the first conductivity type, formed on the first semiconductor active region, an impurity concentration thereof being greater than $5 \times 10^{18}$ cm$^{-3}$,

a third semiconductor active region, of the first conductivity type, formed on the second semiconductor active region, an impurity concentration thereof being less than that of the second region, and

a plurality of electrodes, the electrodes being electrically connected respectively to said first, second and third semiconductor active regions and being mutually isolated one from another. According to the present invention there is provided a bipolar transistor for operation at temperatures below about minus 100 degrees centigrade, said bipolar transistor comprising:-

a semiconductor substrate of a first conductivity type,

a buried collector layer, formed in said substrate, having a second conductivity type, opposite to the first conductivity type,

a collector layer, of the second conductivity type, formed on said buried collector layer,

a base layer, of the first conductivity type, formed on said collector layer, an impurity concentration thereof being greater than $5 \times 10^{18}$ cm$^{-3}$,

an emitter layer, of the second conductivity type, formed on said base layer, an impurity concentration thereof being less than that of said base layer, and

collector, base, and emitter electrodes, each electrode formed on/above and connected electrically to said buried collector layer, base layer, and emitter layer respectively.

An embodiment of the present invention can provide a bipolar transistor which exhibits a high performance at temperatures below 100° C.

An embodiment of the present invention can provide a semiconductor device which satisfactorily operates in a low temperature range. An embodiment of this invention can provide a bipolar transistor having a current amplification factor $h_{FE}$ of sufficiently high value at temperatures lower than minus 100° C.

An embodiment of the invention can provide a bipolar transistor having a characteristic such that a current amplification factor thereof increases as the operating temperature is reduced.

An embodiment of the present invention can provide a bipolar transistor in which a base resistance $R_b$ is desirably low.

An embodiment of the present invention can provide a structure of a bipolar transistor, for the fabrication of which most conventional wafer processes are applicable with minor modification.

In accordance with an embodiment of the present invention, a bipolar transistor uses a base layer having an impurity concentration of greater than $5 \times 10^{18}$ cm$^{-3}$, and further uses an emitter layer having an impurity concentration sufficiently less than that of the base layer.

By forming the base and emitter layers having impurity concentrations as described above, the value $(\Delta E_{gb} - \Delta E_{ge})$ in equation (1) is made positive, whereas a negative value applies in conventional bipolar transistors. Therefore, the exponential term $\exp(\Delta E_{gb} - \Delta E_{ge})/kT$ in equation (1), in a case of the bipolar transistor embodying the present invention, will generate a remarkably large value, which increases with a decrease of the temperature T. As a result, an $h_{FE}$ value of sufficiently high level can be obtained even when $N_e/N_b$ is very small and the device is operated at temperatures below minus 100° C.

Reference is made, by way of example, to the accompanying drawings, in which:-

Fig. 1 is a schematic cross-sectional view of a previously proposed bipolar transistor;

Fig. 2 is a graph showing impurity concentration profiles of layers in the bipolar transistor of Fig. 1;

Fig. 3 is a graph showing a curve representing the relationship between current amplification factor and operating temperature, for a conventional bipolar transistor;

Fig. 4 is a schematic cross-sectional view of a semiconductor device in accordance with an embodiment of the present invention;

Fig. 5 is a graph showing a curve representing a relationship between a bandgap narrowing effect and arsenic impurity concentration amount;

Fig. 6 is a graph illustrating calculated values of $\exp(\Delta E_{gb} - \Delta E_{ge})/kT$ when operating temperature is varied, wherein the calculated data values are obtained by varying a parameter representing a difference between bandgap narrowing effects;

Fig. 7 is a graph showing impurity doping profile curves of an embodiment of the present invention;

Fig. 8 is a graph showing idealised impurity doping profile curves for a device in accordance with an embodiment of the present invention;

Fig. 9 is a graph illustrating a bandgap narrowing effect for the device shown in Fig. 8; and

Fig. 10 is a graph giving an example of measured current amplification factor data for various operating temperatures.

Fig. 4 is a schematic cross-sectional view of a bipolar transistor according to an embodiment of the present invention. A p-type silicon substrate 11 is used. On a surface of the substrate 11, n$^+$-type impurities are diffused forming a buried collector layer 12. An n$^-$-type epitaxial layer 13, 13' is grown thereon, and thick isolation layers 17, 18 of $SiO_2$ are formed therein by thermal oxidation. These steps are similar to steps mentioned in relation to Fig. 1.

P-type ions are implanted selectively into a surface of the epitaxial layer corresponding to a base formation region 20, to form a p-type base layer 14. A lower portion of the epitaxial layer forms an epitaxial collector layer 13. In the above ion implantation process, the concentration density of boron ions is strictly controlled to be greater than $5 \times 10^{18}$ cm$^{-3}$, preferably greater than $1 \times 10^{19}$ cm$^{-3}$. After forming the base layer 14, a further n$^-$-type epitaxial layer is grown thereon. It is preferable that this growth process be performed with substrate temperature maintained as low as possible. Growth methods such as an MBE (molecular beam epitaxy), solid phase epitaxy, or photo epitaxy are applicable for low temperature epitaxial growth. Thereafter, an n$^+$ layer is formed by an ion implantation into a surface of the further epitaxial layer. Next, a resist mask is formed on an emitter-forming region, and the above epitaxial layer above the base layer 14 is subjected to an etching process, leaving an n$^-$-type emitter layer 15 and an n$^+$-type emitter contact layer 16 thereon. In the above processes, the impurity concentration of the emitter layer 15 is controlled to be less than that of the base layer 14, i.e. less than $5 \times 10^{18}$ cm$^{-3}$, but to be higher than $1 \times 10^{17}$ cm$^{-3}$.

A thin insulating layer 19 is formed on the substrate and contact holes are formed therein. An emitter electrode E, base electrode B and collector electrode C are formed by conventional methods, completing the fabrication of the bipolar transistor in accordance with an embodiment of the present invention.

Cooling means 30 are shown in Fig. 4. These means are provided with the object of maintaining the device in a cryogenic condition.

It is to be noted that in the above embodiment the base layer has an impurity concentration of greater than $5 \times 10^{18}$ cm$^{-3}$, preferably greater than $1 \times 10^{19}$ cm$^{-3}$, and the emitter layer has an impurity concentration less than that of the base, e.g. less than $5 \times 10^{18}$ cm$^{-3}$. The impurity concentration of the emitter layer is nonetheless preferably higher than $1 \times 10^{17}$ cm$^{-3}$. The reason for this will now be explained in more detail.

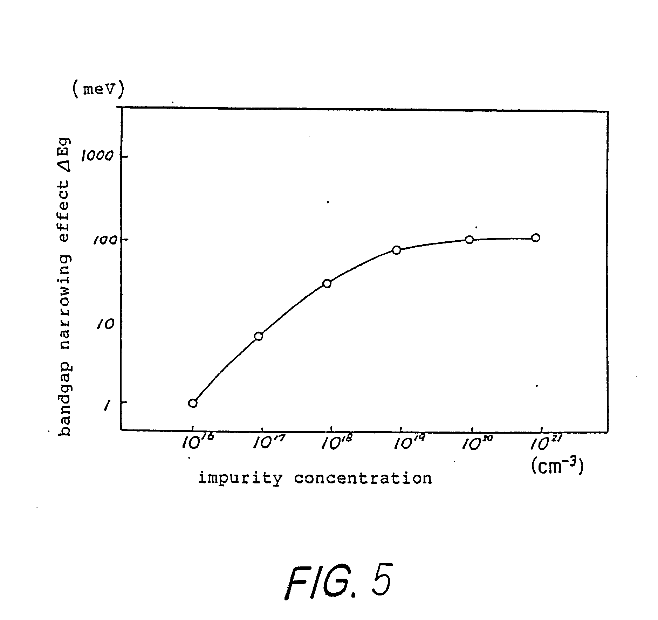

The graph of Fig. 5 shows a curve illustrating bandgap narrowing effects, measured for silicon doped with arsenic ions. The ordinate shows the bandgap narrowing effect $\Delta E_g$ in meV, and the abscissa shows the impurity concentration amount N per cubic cm. In a conventional bipolar transistor, $(\Delta E_{gb} - \Delta E_{ge})$ takes values ranging between about -50 and -100 meV.

The denominator kT of the exponent in equation (1) is given by the following equation:-

$$kT = 1.38066 \times 10^{-23}T \ (J)$$
$$= 8.617 \times 10^{-2}T \ (meV).$$

When T = 300$^\circ$K (room temperature), the value of kT is approximately 26 meV. And when T = 77$^\circ$K (liquid nitrogen temperature), the value of kT is approximately 6.6 meV.

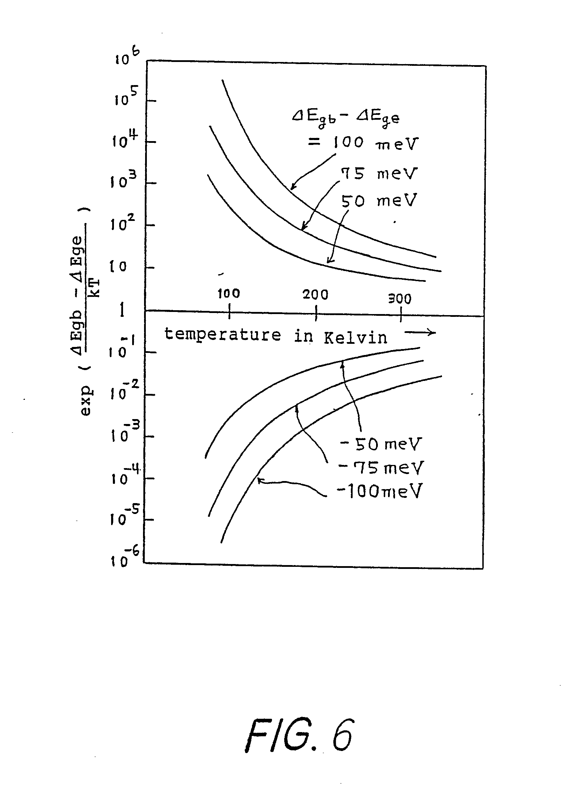

Typical calculation results for $\exp(\Delta E_{gb} - \Delta E_{ge})/kT$ for conventional transistors are shown in the lower part of the graph of Fig. 6, where the values calculated are very small in a low temperature range below 200$^\circ$K. The $N_e/N_b$ value of equation (1), on the other hand, cannot be increased unlimitedly because of the restrictions explained previously. Therefore, the $h_{FE}$ value of a prior art bipolar transistor becomes very small in a low temperature range, with the result that provision of an amplifying function for the transistor is impossible.

In embodiments of the present invention different values of $(\Delta E_{gb} - \Delta E_{ge})$ are provided, for example in a range between +50 and +100 meV, by setting impurity concentrations for the base and emitter layers at appropriate values as described. The exponent term $(\Delta E_{gb} - \Delta E_{ge})/kT$ then provides positive values. Plots of $\exp(\Delta E_{gb} - \Delta E_{ge})/kT$ when impurity concentrations for the base and emitter layers are set at appropriate values are shown in an upper part of the graph of Fig. 6. The curves show that the value of the exponent increases with decreasing temperature. Even though $N_e/N_b$ is selected to be sufficiently small, for example 1/100 to 1/1000, as applied in the embodiment of Fig. 4, the $h_{FE}$ value is high enough in the low temperature range.

The impurity concentrations of the base and emitter layers of embodiments of the present invention are determined in such a way that a difference $(\Delta E_{gb} - \Delta E_{ge})$ between the bandgap narrowing effects of the base and emitter layers is greater than about 50 meV. To reduce the base layer resistance Rb, the impurity concentration of the base layer is desirably as high as possible consistent with the above goal. In practical embodiments, the base layer impurity concentration is greater than $5 \times 10^{18}$ cm$^{-3}$, preferably $1 \times 10^{19}$ cm$^{-3}$ or higher.

On the other hand, the impurity concentration of the emitter layer is required to be lower than that of the base layer and to differ sufficiently therefrom. However, the emitter layer resistance $R_e$ is also required to be less than a transistor operation parameter $r_e$ expressed by $kT/qI_E$. Herein, q denotes the charge per carrier (for electrons or holes), and $I_E$ denotes an emitter current. As a result, the impurity concentration of the emitter layer in embodiments of the present invention is preferably selected to be greater than $1 \times 10^{17}$ cm$^{-3}$, but to have enough difference from that of the base layer.

The marked decrease of the emitter impurity concentration compared with that of conventional bipolar transistors also contributes to provide a decrease in emitter capacitance $C_{EB}$, which is also effective for encouraging high-speed operation.

In the embodiment of Fig. 4, the emitter contact layer 16 of highly doped silicon is formed on the emitter layer 15, which reduces emitter contact resistance with the emitter electrode E.

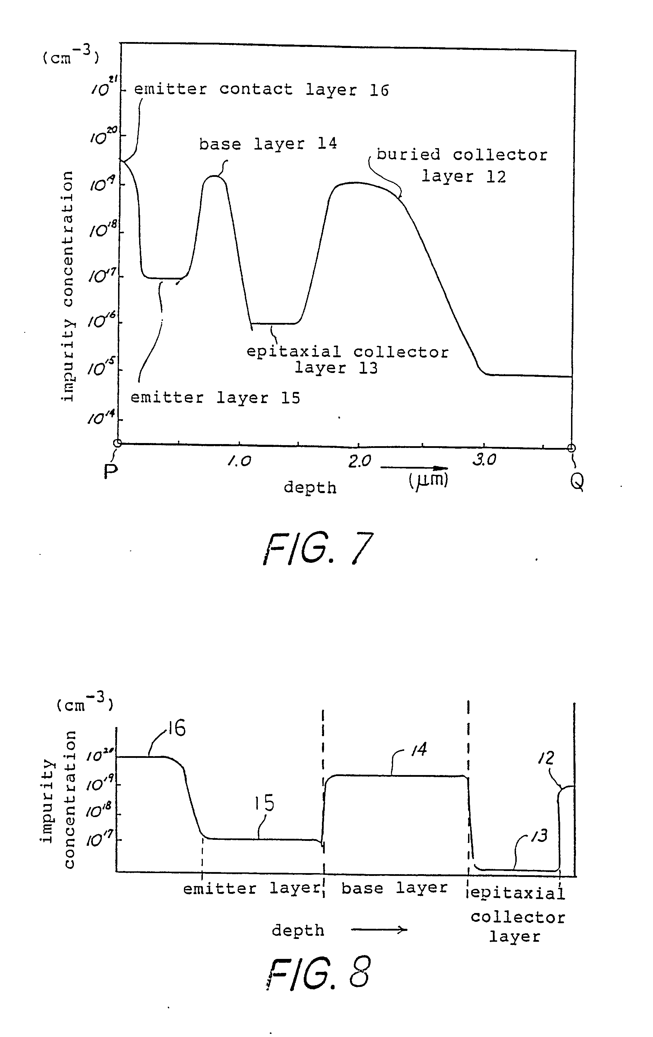

The graph of Fig. 7 shows curves of the impurity concentration data, for all layers of the embodiment of the present invention of Fig. 4. The abscissa shows vertical depth from point P on a surface of the emitter contact layer 16, and the ordinate shows the impurity concentration data.

As a design objective for embodiments of the present invention (that is, representing a model for such embodiments) the impurity concentration data profile shown in the graph of Fig. 8, can be taken, in which each of laminated layers shows almost a flat characteristic. In Fig. 8 (as in Fig. 7), the impurity concentration of the base layer 14 is selected to be larger than $5 \times 10^{18}$ cm$^{-3}$, preferably a little larger than $1 \times 10^{19}$ cm$^{-3}$. By using a base layer 14 of this kind, base layer resistance $R_b$ can be decreased to a sufficiently low value for high-speed operation.

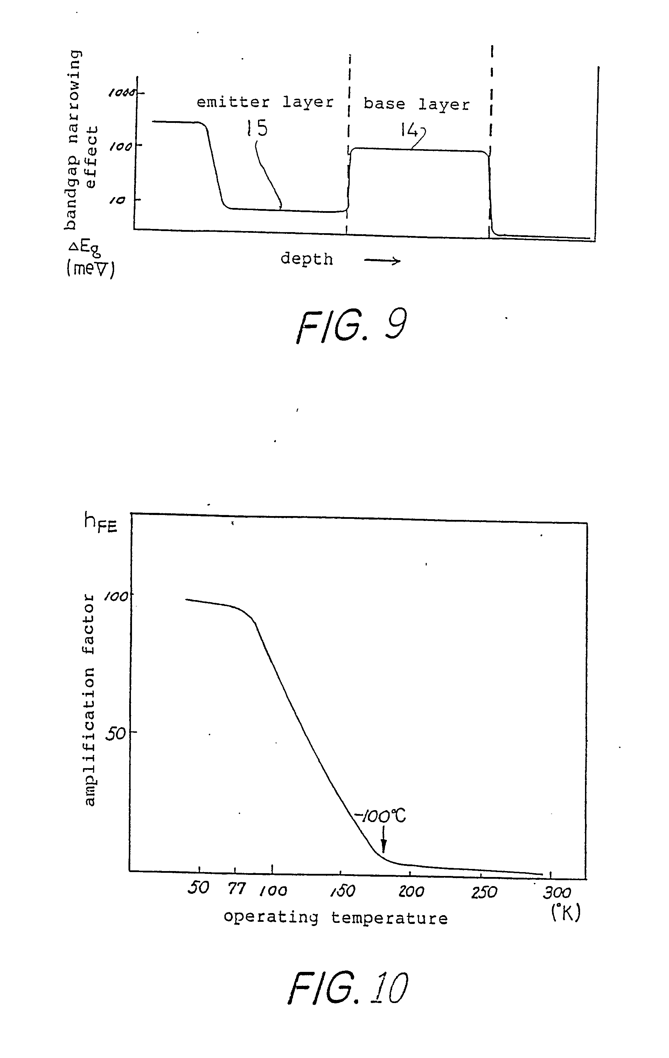

The bandgap narrowing effect of each layer of a device structured in accordance with the model of Fig. 8 is shown in Fig. 9. The difference value $(\Delta E_{gb} - \Delta E_{ge})$ between the base layer 14 and emitter layer 15 takes a positive value of about 100 meV. Though the $\exp(\Delta E_{gb} - \Delta E_{ge})/kT$ term takes a value of about 50 at room temperature (300$^\circ$K), it takes a high value of about $1 \times 10^5$ at 100$^\circ$K. The current amplification factor $h_{FE}$ of equation (1), therefore, will also give a sufficiently large value even when the $N_e/N_b$ value is small, for example less than 1/100.

A semiconductor device (e.g. a bipolar transistor, in accordance with an embodiment of the present invention should be cooled during operation, to a temperature in the range below about -100$^\circ$C (173$^\circ$K). In the embodiment shown in Fig. 4, a cooling means 30 is added to the active semiconductor device. In a practical application, the cooling means may be a liquid nitrogen circulating cooler or cryostat means in which the semiconductor active element is installed, and by utilising these cooling means it is an easy matter to obtain a cryogenic operating temperature below -100$^\circ$C.

The graph of Fig. 10 shows an example of measured data relating to amplification factor $h_{FE}$, in which the abscissa shows operating temperature in Kelvin. The $h_{FE}$ curve increases rapidly with decrease in temperature in a range below 100$^\circ$C, and then saturates below about 77$^\circ$K. The saturation is caused by phenomena such as leakage current or recombination current in the active layers of the device.

It may be noted that the feature of having the impurity concentrations of the emitter and collector layers both lower than that of the base layer opens up a possibility of a reversed operation, in which the collector layer 13 may be used as an emitter layer and the emitter layer 15 as a collector layer. The collector may, for example, have an impurity concentration of around $1 \times 10^{16}$ cm$^{-3}$. This reversed operation is impossible for a conventional bipolar transistor in which the impurity concentration of the layers increases in the order of deposition, from the collector layer.

The present invention may be embodied in specific forms other than those described above. For instance, other bipolar transistor structures can be modified, by providing suitable impurity concentrations for active layers in accordance with the present invention.

An embodiment of the present invention can provide a semiconductor device which works, without deterioration of performance, under cryogenic conditions. The device has a structure similar to that of conventional bipolar transistors, but a different impurity doping profile. The impurity concentration for a "base" layer of the device is controlled to be larger than $5 \times 10^{18}$ cm$^{-3}$, preferably $1 \times 10^{19}$ cm$^{-3}$ or more, and the impurity concentration for an "emitter" layer is controlled to be in a limited range less than the above value, but greater than $1 \times 10^{17}$ cm$^{-3}$. The above doping profile enables the device to operate satisfactorily at temperatures below about minus 100 decrees centigrade, down to liquid nitrogen temperatures, and further makes it suitable for a high-speed operation.

## Claims

1. A semiconductor device for operation at temperatures below about minus 100 degrees centigrade, said semiconductor device comprising:-
a semiconductor substrate,
a first semiconductor active region, of a first conductivity type, formed on the substrate,
a second semiconductor active region, of a second conductivity type, opposite to the first conductivity type, formed on the first semiconductor active region, an impurity concentration thereof being greater than $5 \times 10^{18}$ cm$^{-3}$,
a third semiconductor active region, of the first conductivity type, formed on the second semiconductor active region, an impurity concentration thereof being less than that of the second region, and
a plurality of electrodes, the electrodes being electrically connected respectively to said first, second and third semiconductor active regions and being mutually isolated one from another.

2. A semiconductor device as claimed in claim 1, wherein said second semiconductor active region has an impurity concentration greater than $1 \times 10^{19}$ cm$^{-3}$.

3. A semiconductor device as claimed in claim 1 or 2, wherein said third semiconductor active region has an impurity concentration greater than $1 \times 10^{17}$ cm$^{-3}$.

4. A semiconductor device as claimed in claim 1, 2 or 3, wherein a difference between bandgap narrowing effects of said second and third semiconductor active regions is greater than 50 meV (milli-electron-volts).

5. A semiconductor device as claimed in claims 1, 2, 3 or 4, wherein said first semiconductor active region has an impurity concentration less than that of said second semiconductor region, preferably around $1 \times 10^{16}$ cm$^{-3}$.

6. A semiconductor device as claimed in any preceding claim, wherein said first semiconductor active region is a part of an epitaxial layer formed on said substrate, and said second semiconductor active region is a selectively doped region in the epitaxial layer, and said third semiconductor active region forms a protruding shape on said second semiconductor region.

7. A semiconductor device as claimed in claim 6, wherein a buried layer of high impurity concentration, greater than that of the first semiconductor active region, is selectively formed in the substrate, which is of the second conductivity type, said first semiconductor active region being formed on a part of the buried layer, and one electrode is formed on a laterally extended region of the buried layer.

8. A bipolar transistor for operation at temperatures below about minus 100 degrees centigrade, said bipolar transistor comprising:-
a semiconductor substrate of a first conductivity type,
a buried collector layer, formed in said substrate, having a second conductivity type, opposite to the first conductivity type,
a collector layer, of the second conductivity type, formed on said buried collector layer,
a base layer, of the first conductivity type, formed on said collector layer, an impurity concentration thereof being greater than $5 \times 10^{18}$ cm$^{-3}$,
an emitter layer, of the second conductivity type, formed on said base layer, an impurity concentration thereof being less than that of said base layer, and
collector, base, and emitter electrodes, each electrode formed on/above and connected electrically to said buried collector layer, base layer, and emitter layer respectively.

9. A bipolar transistor as claimed in claim 8, wherein said base layer has an impurity concentration greater than $1 \times 10^{19}$ cm$^{-3}$.

10. A bipolar transistor as claimed in claim 8 or 9, wherein said emitter layer has an impurity concentration greater than $1 \times 10^{17}$ cm$^{-3}$.

11. A bipolar transistor as claimed in claim 8, 9 or 10, wherein a difference between bandgap narrowing effects of said base and emitter layers is greater than 50 meV (milli-electron-volts).

12. A bipolar transistor as claimed in claims 8, 9, 10 or 11, wherein said collector layer has an impurity concentration less than that of said base layer, preferably around $1 \times 10^{16}$ cm$^{-3}$.

13. A bipolar transistor as claimed in any of claims 8 to 12, wherein said collector layer is a part of an epitaxial layer formed on said buried collector layer, and said base layer is a selectively doped region in the epitaxial layer, and said emitter layer forms a protruding shape on said base layer.

14. A bipolar transistor as claimed in claim 13, wherein said buried collector layer has an impurity concentration greater than that of said collector layer and is selectively formed in said substrate, said collector layer being formed on a part of the buried collector layer, and said collector electrode is formed on a laterally extended region of the buried layer.

15. A semiconductor device or a bipolar transistor, as the case may be, as claimed in any preceding claim, provided with means for cooling the substrate and associated elements formed thereon to a temperature below about minus 100 degrees centigrade.

*FIG. 1*

*FIG. 2*

*FIG. 3*

*FIG. 4*

FIG. 5

FIG. 6

**FIG. 7**

**FIG. 8**

FIG. 9

FIG. 10